# EUROPÄISCHE PATENTSCHRIFT

(11) **EP 1 389 407 B1**
(45) Veröffentlichungstag und Bekanntmachung des Hinweises auf die Patenterteilung: **17.08.2011**
(21) Anmeldenummer: 02747159.8
(22) Anmeldetag: 22.05.2002
(51) Int. Cl.: H05K 3/40

(54) **VERFAHREN ZUR HERSTELLUNG EINES KONTAKTSUBSTRATS SOWIE KONTAKTSUBSTRAT**
METHOD FOR PRODUCING A CONTACT SUBSTRATE, AND CORRESPONDING CONTACT SUBSTRATE
PROCEDE DE REALISATION D'UN SUBSTRAT DE CONTACT, ET SUBSTRAT DE CONTACT CORRESPONDANT

(30) Priorität: 23.05.2001 DE 10125497
(43) Veröffentlichungstag der Anmeldung: 18.02.2004
(73) Patentinhaber: Pac Tech - Packaging Technologies GmbH, 14641 Nauen (DE); Smart Pac GmbH Technology Services, 14641 Nauen (DE)
(72) Erfinder: ZAKEL, Elke, 14612 Falkensee (DE); AZDASHT, Ghassem, 14052 Berlin (DE)
(74) Vertreter: Tappe, Hartmut
(86) Internationale Anmeldenummer: PCT/DE2002/001865
(87) Internationale Veröffentlichungsnummer: WO 2002/096170

(56) Entgegenhaltungen:
- EP-A- 0 561 620
- US-A- 6 013 876
- PATENT ABSTRACTS OF JAPAN vol. 017, no. 401 (E-1404), 27. Juli 1993 (1993-07-27) & JP 05 075253 A (HITACHI CONSTR MACH CO LTD), 26. März 1993 (1993-03-26)
- PATENT ABSTRACTS OF JAPAN vol. 015, no. 288 (E-1092), 22. Juli 1991 (1991-07-22) -& JP 03 101191 A (FUJITSU LTD), 25. April 1991 (1991-04-25)
- PATENT ABSTRACTS OF JAPAN vol. 1997, no. 03, 31. März 1997 (1997-03-31) -& JP 08 307058 A (TOAGOSEI CO LTD), 22. November 1996 (1996-11-22)
- PATENT ABSTRACTS OF JAPAN vol. 1999, no. 03, 31. März 1999 (1999-03-31) -& JP 10 326962 A (CMK CORP), 8. Dezember 1998 (1998-12-08)
- PATENT ABSTRACTS OF JAPAN vol. 017, no. 192 (E-1350), 14. April 1993 (1993-04-14) -& JP 04 337695 A (HITACHI CABLE LTD), 25. November 1992 (1992-11-25)
- PATENT ABSTRACTS OF JAPAN vol. 016, no. 014 (E-1154), 14. Januar 1992 (1992-01-14) & JP 03 233996 A (MATSUSHITA ELECTRIC IND CO LTD), 17. Oktober 1991 (1991-10-17)

## Beschreibung

Die vorliegende Erfindung betrifft ein Verfahren zur Herstellung eines Kontaktsubstrats mit Durchkontaktierungen zwischen einer auf einer Oberseite eines dielektrischen Trägersubstrats angeordneten Anschlussleiteranordnung und einer Unterseite des Trägersubstrats, wobei sich die Anschlussleiteranordnung längs eines Öffnungsrands einer Substratausnehmung erstreckt und das Trägersubstrat sich mit seiner Unterseite an einem Gegenhalter abstützt. Des Weiteren betrifft die Erfindung ein Kontaktsubstrats mit einer Durchkontaktierung umfassend ein Trägersubstrat und eine auf dem Trägersubstrat angeordnete Leiterbahnstruktur gemäß dem Oberbegriff der Ansprüche 12 bzw. 15.

Durchkontaktierungen der eingangs genannten Art werden verwendet, um auf einander gegenüberliegenden Seiten eines dielektrischen Trägersubstrats angeordnete Anschlussleiteranordnungen elektrisch miteinander zu verbinden, oder bei nur einseitiger Anordnung einer Anschlussleiteranordnung auf einem Trägersubstrat eine Kontaktierung der Anschlussleiteranordnung von der Gegenseite her zu ermöglichen, und so beispielsweise eine beidseitige Bestückung entsprechend ausgebildeter Kontaktsubstrate mit elektronischen Bauelementen zu ermöglichen. Bislang werden hierzu Kontaktsubstrate verwendet, bei denen bereits vor Herstellung der eigentlichen Durchkontaktierung ein mechanisch haftender Verbund der Anschlussleiteranordnung mit dem Trägersubstrat besteht. In der Regel bedeutet dies, dass als Kontaktsubstrate Substratträger verwendet werden, die in einem vorhergehenden mehr oder weniger aufwendigen Verfahren mit einer haftend auf die Oberfläche des Trägersubstrats aufgebrachten Anschlussleiteranordnung versehen sind. Bekannte Verfahren, die hierzu verwendet werden, sind beispielsweise fotolithografische Ätzverfahren oder chemische Abscheideverfahren.

Zur Herstellung der eigentlichen Durchkontaktierung wird zwischen den beidseitig auf dem Trägersubstrat angeordneten Anschlussleiteranordnungen eine elektrisch leitende Verbindung aus einem geeigneten Verbindungsmaterial, wie beispielsweise einem Lot, geschaffen. US-A- 6013876 offenbart ein Verfahren und ein Kontaktsubstrab gemäß den jeweiligen Oberbegriffen der Ansprüche 1, 12 und 15.

Der vorliegenden Erfindung liegt die Aufgabe zugrunde, ein Verfahren zur Herstellung von Kontaktsubstraten sowie ein Kontaktsubstrat vorzuschlagen, das eine vereinfachte Herstellung von Kontaktsubstraten ermöglicht.

Zur Lösung dieser Aufgabe weist das erfindungsgemäße Verfahren die Merkmale des Anspruchs 1 auf.

Bei dem erfindungsgemäßen Verfahren wird ein Lotmaterialformstück in die Substratausnehmung eingebracht und in einem nachfolgenden Verfahrensschritt innerhalb der Substratausnehmung zu einem Kontaktformstück verformt, derart, dass durch eine radiale Verdrängung des Materials des Formkörpers in der Substratausnehmung eine kraftschlüssige Verbindung zwischen einer Laibungsfläche der Substratausnehmung und der Anschlussleiteranordnung erfolgt, und das Kontaktformstück eine Durchkontaktierung zwischen der Anschlussleiteranordnung und der Unterseite des Trägersubstrats bildet.

Die Durchführung des vorstehenden Verfahrens ermöglicht somit die Herstellung eines Kontaktsubstrats ausgehend von einem Trägersubstrat und einer unabhängig vom Trägersubstrat ausgebildeten Anschlussleiteranordnung. Aufgrund der kraftschlüssigen Verbindung zwischen dem Trägersubstrat und der Anschlussleiteranordnung mittels des verformten Kontaktformstücks wird nicht nur eine elektrisch leitfähige, sondern gleichzeitig auch eine mechanische Verbindung zwischen der Anschlussleiteranordnung und dem Trägersubstrat ermöglicht. Ein entscheidender Vorteil des erfindungsgemäßen Verfahrens liegt daher darin, dass es zur Herstellung des mit einer Durchkontaktierung versehenen Kontaktsubstrats nicht notwendig ist, einen Substratträger zuvor auf seiner Oberfläche mit einer darauf haftenden Anschlussleiteranordnung zu versehen. Vielmehr kann die mechanische Verbindung der Anschlussleiteranordnung mit Herstellung der Durchkontaktierung geschaffen werden.

Bei einer vorteilhaften Verfahrensvariante erfolgt die Verdrängung unter Ausbildung eines scheibenförmigen, den Öffnungsrand der Substratausnehmung sowohl axial als auch radial überragenden Kontaktkopfs, wobei die Anschlussleiteranordnung im Bereich des Öffnungsrands zwischen dem Kontaktkopf und der Oberseite des Trägersubstrats aufgenommen wird. Hierdurch wird eine besonders stabile mechanische Verbindung, vergleichbar einer sogenannten "Blindnietverbindung", ermöglicht.

Bei einer weiteren vorteilhaften Verfahrensvariante erfolgt die radiale Verdrängung des Materials des Lotmaterialformstücks mittels eines Druckstempels mit konvex ausgebildeter Kontaktfläche, derart, dass neben einer radialen Verdrängung auch eine axiale Verdrängung des Materials entgegen der Druckrichtung des Druckstempels bewirkt wird. Dabei kann das Volumen des Lotmaterials auch kleiner bemessen sein als das Lumen der Substratausnehmung, ohne dass die kraftschlüssige mechanische Verbindung beeinträchtigt wird.

Wenn dabei darüber hinaus die Druckbeaufschlagung mittels eines auf seiner Kontaktfläche mit einer Zentriereinrichtung versehenen Druckstempels erfolgt, wird eine sowohl radial als auch axial gleichmäßig verteilte Verdrängung, also ein zur Mittelachse der Ausnehmung symmetrischer Verdrängungszustand, möglich.

Als besonders vorteilhaft erweist es sich auch, wenn in einem Verfahrensschritt nachfolgend der Umformung des Lotmaterialformstücks zu einem Kontaktformstück innerhalb der Substratausnehmung das Material des Formstücks zumindest anteilig umgeschmolzen wird. Auf diese Art und Weise kann die durch Umformung des Formkörpers hergestellte rein kraftschlüssige Verbindung, die in jedem Fall eine zumindest temporäre Fixierung der Anschlussleiteranordnung auf dem Trägersubstrat ermöglicht, in eine stoffschlüssige permanente Fixierung umgewandelt werden. Dies mag sich besonders in den Fällen als vorteilhaft erweisen, in denen erhöhte Anforderungen an die Zuverlässigkeit der an sich zur Herstellung einer mechanischen und elektrischen Verbindung ausreichenden kraftschlüssigen Verbindung gestellt werden.

Wenn das Umschmelzen mittels Laserenergie erfolgt, wird ein Umschmelzen lediglich eines lokal definierten Anteils bis hin zu einem vollständigen Umschmelzen möglich.

Wenn gemäß einer vorteilhaften Variante des Verfahrens vor Einbringung des Lotmaterialformstücks in die Substratausnehmung auf die Unterseite des Trägersubstrats zwischen dem Trägersubstrat und dem Gegenhalter eine zweite Anschlussleiteranordnung angeordnet wird, derart, dass die zweite Anschlussleiteranordnung zumindest anteilig einen Boden der Substratausnehmung bildet, wird durch das Umschmelzen des Kontaktformstücks eine mechanisch haltende und elektrisch leitende Verbindung zwischen beidseitig des Trägersubstrats angeordneten Anschlussleiteranordnungen ermöglicht, so dass ein Kontaktsubstrat geschaffen wird, das eine schaltungstechnische Verbindung beidseitig auf dem Kontaktsubstrat kontaktierter elektronischer Bauelemente ermöglicht.

Eine Alternative zur Ausbildung des beidseitig mit Anschlussleiteranordnungen versehenen Kontaktsubstrats wird möglich, wenn vor Einbringung des Lotmaterialformstücks in die Substratausnehmung auf der Unterseite des Trägersubstrats zwischen dem Substrat und dem Gegenhalter eine zweite Anschlussleiteranordnung angeordnet wird, derart, dass sich die zweite Anschlussleiteranordnung längs einem unteren Öffnungsrand der Substratausnehmung erstreckt.

Wenn unabhängig von der gewählten Verfahrensvariante vor dem Umschmelzen des in der Substratausnehmung angeordneten Kontaktformstücks auf den Kontaktkopf ein weiteres Lotmaterialformstück aufgebracht wird und anschließend das Lotmaterial zumindest anteilig umgeschmolzen wird, ist es möglich, die Durchkontaktierungen gleichzeitig als Kontakterhöhungen auszubilden, die fachsprachlich als sogenannte "Bumps" bezeichnet werden. Damit können die Durchkontaktierungen beispielsweise gleichzeitig zur Ausbildung von Bump-Verteilungen, wie "Ball-Grid-Arrays", oder ähnlichem verwendet werden, die auf besonders einfache Art und Weise eine sogenannte "Flip-Chip-Kontaktierung" der Kontaktsubstrate ermöglichen. Auch dieses Umschmelzen kann mittels Laserenergie erfolgen.

Das erfindungsgemäße Kontaktsubstrat weist in einer ersten Variante die Merkmale des Anspruchs 12 und in einer weiteren unabhängigen Variante die Merkmale des Anspruchs 15 auf.

Bei dem erfindungsgemäßen Kontaktsubstrat gemäß Anspruch 12 ist eine elektrisch leitfähige Verbindung zwischen der unteren Anschlussleiteranordnung und der oberen Anschlussleiteranordnung über ein Kontaktformstück gebildet, derart, dass das Kontaktformstück die Substratausnehmung vollständig ausfüllt, und das Kontaktformstück an seinem, dem Boden der Substratausnehmung gegenüberliegenden Ende einen den Öffnungsrand sowohl axial als auch radial überragenden Kontaktkopf aufweist, der mit der oberen Anschlussleiteranordnung kraftschlüssig verbunden ist.

Bei dem erfindungsgemäß ausgebildeten Kontaktsubstrat ermöglicht somit die Durchkontaktierung neben einer elektrisch leitfähigen Verbindung zwischen den auf gegenüberliegenden Seiten des Trägersubstrats angeordneten Anschlussleiteranordnungen eine mechanische Verbindung der Anschlussleiteranordnungen untereinander, die zur Fixierung der Anschlussleiteranordnungen auf dem Trägersubstrat dient. Darüber hinaus ist es aufgrund der Ausbildung der Durchkontaktierung aus einem Lotmaterialformstück möglich, ohne weitere Zwischenschritte das Lotmaterial der Durchkontaktierung zur Herstellung einer stoffschlüssigen Verbindung mit auf dem Kontaktsubstrat zu kontaktierenden elektronischen Bauelementen zu nutzen.

Zum Aufbau eines Kontaktsubstrats, das aus einem Trägersubstratverbund gebildet ist, ist es möglich, die untere Leiterbahnanordnung auf einem weiteren Trägersubstrat anzuordnen.

Die Durchkontaktierung im Kontaktsubstrat kann durch einen rein mechanischen Umformvorgang gebildet sein, derart, dass der Kontaktkopf scheibenförmig ausgebildet ist und eine im Wesentlichen ebene und parallel zur Oberfläche des Trägersubstrats ausgebildete Kontaktfläche aufweist.

Die durch die Kontalctformstücke gebildeten Durchkontaktierungen des Kontaktsubstrats können alternativ auch nach dem mechanischen Umformvorgang umgeschmolzen sein, derart, dass der Kontaktkopf eine meniskusförmige Kontakterhöhung aufweist.

Bei der weiteren erfindungsgemäßen Variante nach Anspruch 15 ist eine elektrisch leitfähige Verbindung zwischen der unteren Anschlussleiteranordnung und der oberen Anschlussleiteranordnung über ein Kontaktformstück gebildet, derart, dass das Kontaktformstück an seinem dem Boden der Substratausnehmung gegenüberliegenden Ende eine konkave Kontaktoberfläche mit einem erhöhten Kontaktrand aufweist, der mit der oberen Anschlussleiteranordnung kraftschlüssig verbunden ist. Aufgrund des erhöht ausgebildeten Kontaktrandes ist es nicht notwendig, dass das Kontaktformstück die Substratausnehmung vollständig ausfüllt.

Wenn die zweite Anschlussleiteranordnung auf einem weiteren Trägersubstrat angeordnet ist, lässt sich das Kontaktsubstrat auch zum Aufbau eines mehrere Trägersubstratlagen aufweisenden Schichtsubstrats verwenden.

Nachfolgend werden bevorzugte Ausführungsformen des Verfahrens sowie nach dem Verfahren hergestellter Kontaktsubstrate anhand der Zeichnungen näher erläutert. Es zeigen:
- F**ig. 1**: eine Trägersubstratanordnung mit zweilagiger Anord- nung von mit Anschlussleiteranordnungen versehenen Trägersubstraten;
- **Fig. 2**: eine Platzierung von Lotmaterialformstücken in Sub- stratausnehmungen der Trägersubstratanordnung ge- mäß **Fig. 1** mit anschließendem Umformvorgang zur Ausbildung von Kontaktformstücken;
- **Fig. 3**: eine Platzierung von weiteren Lotmaterialformstücken auf den Kontaktformstücken mit anschließendem Um- schmelzvorgang zur Ausbildung von Lotbumps;
- **Fig. 4**: ein Kontaktsubstrat in einer ersten Ausführungsform;
- **Fig. 5**: ein Kontaktsubstrat in einer zweiten Ausführungsform;
- **Fig. 6**: die Herstellung eines Kontaktsubstrats mit einer Vari- ante des Kontaktformstücks;
- **Fig. 7**: das in **Fig. 6** dargestellte Kontaktformstück nach ei- nem Umschmelzvorgang.

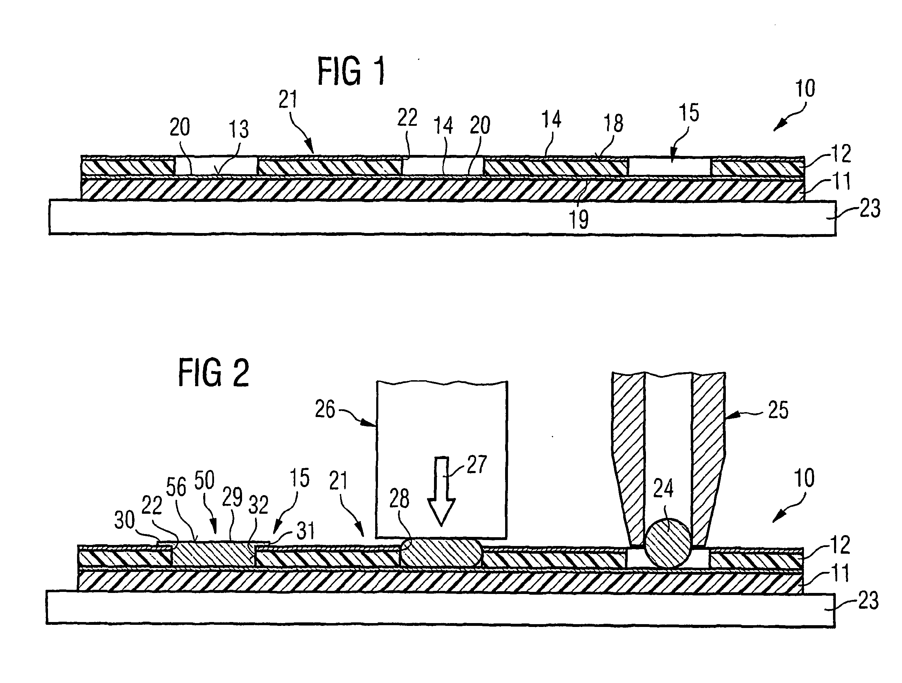

**Fig. 1** zeigt eine Trägersubstratanordnung 10 umfassend ein unteres Trägersubstrat 11 und ein oberes Trägersubstrat 12. Das untere Trägersubstrat 11 ist auf seiner Oberseite 13 mit einer Anschlussleiteranordnung 14 versehen, die im vorliegenden Fall aus einer in Abscheidetechnik auf der Oberseite 13 ausgebildeten Leiterbahnstruktur besteht. Das Trägersubstrat 11 sowie das Trägersubstrat 12 bestehen im vorliegenden Fall aus Polyamid, wobei jedoch grundsätzlich bei dem nachfolgend erläuterten Verfahren auch andere dielektrische Materialien für die Trägersubstrate verwendbar sind. Für die Anschlussleiteranordnung 14 wird im vorliegenden Fall Kupfer oder eine Kupferlegierung verwendet.

Das auf dem Trägersubstrat 11 bzw. der Anschlussleiteranordnung 14 des Trägersubstrats 11 angeordnete Trägersubstrat 12 weist Substratausnehmungen 15 auf, die sich von einer Oberseite 18 des Trägersubstrats 12 bis hin zu einer Unterseite 19 des Trägersubstrats 12 als Durchgangslöcher erstrecken, wobei die Substratausnehmungen 15 nach unten durch die Anschlussleiteranordnung 14 begrenzt werden, die somit jeweils einen Boden 20 der Substratausnehmungen 15 bildet. Auf der Oberseite 18 des Trägersubstrats 12 befindet sich eine weitere Anschlussleiteranordnung 21, die so ausgebildet ist, dass sie sich zumindest anteilig um einen oberen Öffnungsrand 22 der Substratausnehmungen 15 herum erstreckt. Die Anschlussleiteranordnung 21 kann haftend, beispielsweise stoffschlüssig, mit der Oberseite 18 des Trägersubstrats 12 verbunden sein oder auch unabhängig vom Trägersubstrat 12 ausgebildet sein und somit lose auf der Oberseite 18 des Trägersubstrats 12 aufliegen.

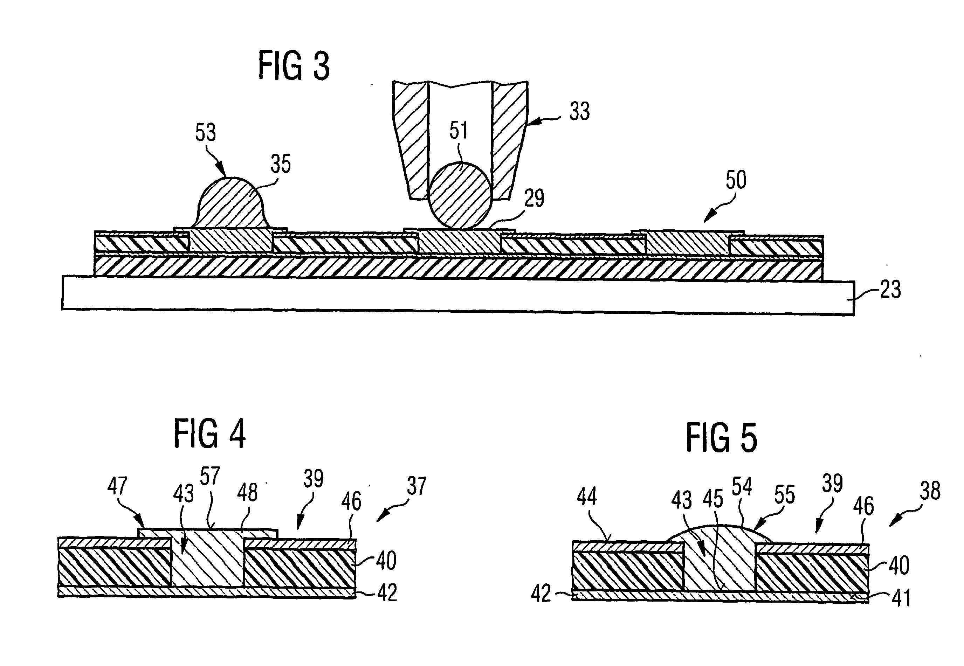

Zur nachfolgend näher erläuterten Durchführung des Verfahrens liegt, wie in **Fig. 1** und den **Fig. 2** und **3** dargestellt, die Trägersubstratanordnung 10 auf einer abstützenden Unterlage 23 auf.

Wie **Fig. 2** zeigt, werden nachfolgend die Substratausnehmungen 15 jeweils in einem ersten Verfahrensschritt mit einem Lotmaterialformstück 24 bestückt. Hierzu wird, wie in **Fig. 2** beispielhaft dargestellt, die Trägersubstratanordnung 10 mittels der hier als Fördereinrichtung ausgebildeten Unterlage 23 in Vorschubrichtung 49 getaktet an einer Bestückungseinrichtung 25 vorbeibewegt. In dem nachfolgenden Verfahrensschritt erfolgt mittels einer mechanischen Umformeinrichtung 26 ein Umformvorgang des Lotmaterialformstücks 24 zu einem Kontaktformstück 50, wobei die Unterlage 23 als Gegenhalter zur Aufnahme einer Umformkraft 27 dient. Das Kontaktformstück 50 bildet eine Durchkontaktierung des Trägersubstrats 12 zwischen den Anschlussleiteranordnungen 14 und 21. Durch die Umformkraft 27 erfolgt eine radiale Verdrängung des Lotmaterials des Lotmaterialformstücks 24, die durch eine im vorliegenden Fall als Zylindermantel ausgebildete Laibungsfläche 28 begrenzt wird. Wegen der plastischen Verformung des Lotmaterials wirkt die Umformkraft 27 auch nach Beendigung des Umformvorgangs radial auf die Laibungsfläche 28. Weiterhin bildet sich aufgrund des im Vergleich zum Lumen der Substratausnehmung 15 größeren Materialvolumens des Lotmaterialformstücks 24 bedingt durch den Umformvorgang am oberen Ende des Kontaktformstücks 50 ein Kontaktkopf 29 aus, wie am Beispiel der in **Fig. 2** linken Substratausnehmung 15 dargestellt. Infolge des Umformvorgangs weist das Kontaktformstück 50 einen radialen Überstand 30 auf, der sich im Bereich des Öffnungsrands 22 über einen zugeordneten Randbereich 31 der Anschlussleiteranordnung 21 erstreckt. Es wird betont, dass der radiale Überstand 30 zur Ausbildung einer zwischen der Anschlussleiteranordnung 21 und dem Trägersubstrat 12 wirkenden Haltekraft nicht notwendig ist. Hierzu reicht allein die vom Kontaktformstück 50 auf die Laibungsfläche 28 und eine entsprechende Laibungsfläche 32 der Anschlussleiteranordnung 21 übertragene, radial wirkende Umfangskraft aus. Lediglich in dem Fall, dass die Anschlussleiteranordnung 21 sich nicht über einen zur Ausbildung der Haltekraft ausreichenden Teilumfang des Öffnungsrands 22 erstreckt, erweist es sich bei einer lose auf der Oberseite 18 des Trägersubstrats 12 angeordneten Anschlussleiteranordnung 21 als notwendig, einen Kontaktkopf 29 mit Überstand 30 auszubilden. Ansonsten erweist sich auch die Ausbildung eines Kontaktkopfs ohne Überstand als ausreichend, der im Wesentlichen bündig zur Umfangsfläche des Kontaktformstücks 50 ausgebildet ist.

**Fig. 3** zeigt die Möglichkeit, in einem nachfolgenden weiteren Verfahrensschritt auf eine Kontaktfläche 56 des Kontaktkopfs 29 des in der Substratausnehmung 15 angeordneten Kontaktformstücks 50 mittels einer Bestückungseinrichtung 33, die vergleichbar oder auch identisch mit der Bestückungseinrichtung 25 ausgebildet sein kann, ein weiteres Lotmaterialformstück 51, das in Übereinstimmung mit oder abweichend von dem Lotmaterialformstück 24 ausgebildet sein kann, zu applizieren und nachfolgend umzuschmelzen. Wie in **Fig. 3** weiter dargestellt, ist das Ergebnis des Umschmelzvorgangs die Ausbildung eines eine Durchkontaktierung bildenden Lotbumps 53 mit einer meniskusförmigen Kontakterhöhung 35 auf dem Kontaktformstück 50. Wie in **Fig. 3** ferner dargestellt, kann sich der aufgrund des mechanischen Umformvorgangs **(****Fig.** 2) am Kontaktformstück 50 ausgebildete Überstand 30 des Kontaktkopfs 29 als Folge der Oberflächenspannung des verflüssigten Lotmaterials zurück entwickeln.

Je nach Art der beim Umschmelzvorgang erfolgenden Wärmeenergiebeaufschlagung des Lotmaterialformstücks 34 und nach Art des für das Lotmaterialformstück 34 gewählten Materials kann ein Aufschmelzen der gesamten aus den Kontaktformstücken 50 und den Lotformstücken 34 gebildeten Lotmaterialmasse oder auch nur ein Aufschmelzen des Lotmaterialformstücks 34 erfolgen.

In den **Fig. 4** und **5** ist ein Kontaktsubstrat 37 **(****Fig. 4****)** und ein Kontaktsubstrat 38 **(****Fig. 5****)** dargestellt, die eine übereinstimmende Trägersubstratanordnung 39 aufweisen. Die Trägersubstratanordnung 39 weist jeweils ein Trägersubstrat 40 auf, das auf seiner Unterseite 41 mit einer haftend auf dem Trägersubstrat 40 angeordneten Anschlussleiteranordnung 42 versehen ist. Das Trägersubstrat 40 weist darüber hinaus eine Substratausnehmung 43 auf, die sich von einer Oberseite 44 bis zu einer Rückseite 45 der Anschlussleiteranordnung 42 erstreckt. Auf der Oberseite 44 des Trägersubstrats 40 ist eine weitere Anschlussleiteranordnung 46 vorgesehen, die unabhängig vom Trägersubstrat 40 ausgebildet ist.

Zur elektrisch leitfähigen Verbindung der Anschlussleiteranordnungen 42 und 46 sowie gleichzeitig zur mechanischen Sicherung der Anschlussleiteranordnung 46 auf der Oberseite 44 des Trägersubstrats 40 ist beim Kontaktsubstrat 37 ein Kontaktformstück 47 mit einem flachen Kontaktkopf 48 **(****Fig. 4****)** nach Art des in **Fig. 2** dargestellten Kontaktformstücks 50 ausgebildet. Der Kontaktkopf 48 weist eine ebene Kontaktfläche 57 auf.

Wie im Vergleich hierzu **Fig. 5** zeigt, kann bei dem Kontaktsubstrat 38 durch ein Umschmelzen des Kontaktformstücks 47 anstatt des flachen Kontaktkopfs 48 **(****Fig. 4****)** auch eine meniskusförmige Kontakterhöhung 54 zur Erzeugung eines Lotbumps **55** als Durchkontaktierung vorgesehen werden.

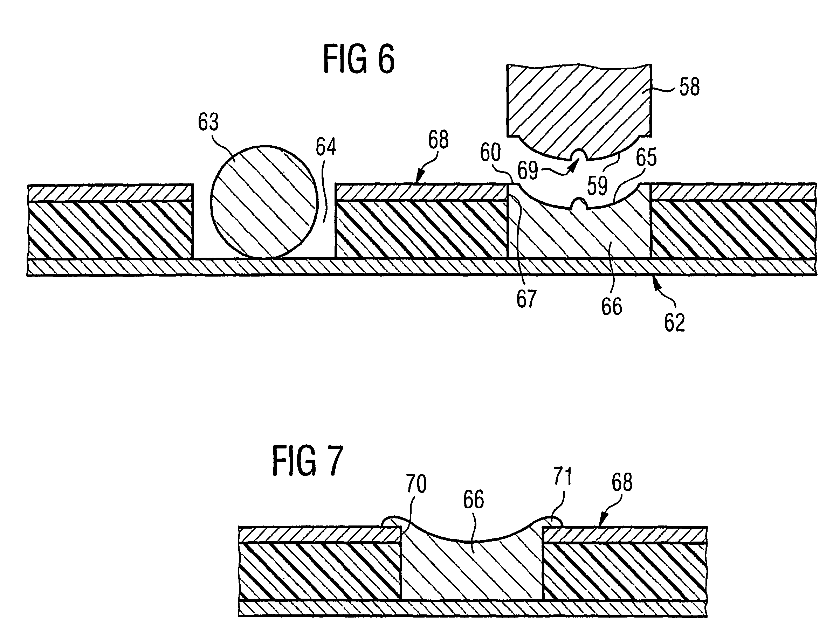

Bei der in **Fig. 6** dargestellten Herstellung eines Kontaktsubstrats 62 erfolgt nach Einbringen eines Lotmaterialformstücks 63 in eine Substratausnehmung 64 eine Druckbeaufschlagung des Lotmaterialformstücks 63 mit einem Druckstempel 58, derart, dass durch eine konvex ausgebildete Kontaktfläche 59 des Druckstempels eine konkav ausgebildete Kontaktoberfläche 65 bei einem Kontaktformstück 66 erzeugt wird. Gleichzeitig hiermit entsteht ein erhöhter Rand 60 des Kontaktformstücks 66, der zumindest eine Laibungsfläche 67 einer oberen Anschlussleiteranordnung 68 bedeckt. Durch eine in der Kontaktfläche 59 des Druckstempels 58 ausgebildete Zentriernut 69 wird erreicht, dass der Rand 60 gleichmäßig ausgebildet wird.

**Fig. 7** zeigt das Kontaktformstück 66 nach einem Umschmelzvorgang mit einem nunmehr infolge der Benetzung der Anschlussleiteranordnung 68 einen Öffnungsrand 70 der Anschlussleiteranordnung 68 sowohl axial als auch radial überragenden Meniskusrand 71.

## Patentansprüche

1. Verfahren zur Herstellung eines Kontaktsubstrats mit Durchkontaktierungen zwischen einer auf einer Oberseite eines dielektrischen Trägersubstrats angeordneten Anschlussleiteranordnung und einer Unterseite des Trägersubstrats, wobei sich die Anschlussleiteranordnung längs eines Öffnungsrands einer Substratausnehmung erstreckt und das Trägersubstrat sich mit seiner Unterseite an einem Gegenhalter abstützt, wobei ein Lotmaterialformstück (24, 51) in die Substratausnehmung (15, 43) eingebracht wird und in einem nachfolgenden Verfahrens- schritt innerhalb der Substratausnehmung eine Verformung des Lotmaterialformstücks zu einem Kontaktformstück (47, 50) erfolgt, derart, dass durch eine radiale Verdrängung des Materials des Lotmaterialformstücks in der Substratausnehmung eine kraftschlüssige Verbindung zwischen einer Laibungsfläche (28) der Substratausnehmung und der Anschlussleiteranordnung (21, 46) erfolgt, und das Kontaktformstück eine Durchkontaktierung zwischen der Anschlussleiteranordnung und der Unterseite (19, 41) des Trägersubstrats bildet
**dadurch gekennzeichnet,**
**dass** die Anschlussleiteranordnung unabhängig vom Trägersubstrat gebildet ist
und eine mechanische Verbindung zwischen der Anschlussleiteranordnung und dem Trägersubstrat vorgesehen wird.

2. Verfahren nach Anspruch 1,
**dadurch gekennzeichnet,**
**dass** die radiale Verdrängung des Materials des Lotmaterialformstücks (24, 51) unter Ausbildung eines scheibenförmigen, den Öffnungsrand (22) sowohl axial als auch radial überragenden Kontaktkopfs (29, 48) erfolgt, und die Anschlussleiteranordnung im Bereich des Öffnungsrands zwischen dem Kontaktkopf und der Oberseite (18, 44) des Trägersubstrats (12, 40) aufgenommen wird.

3. Verfahren nach Anspruch 1,
**dadurch gekennzeichnet,**
**dass** die radiale Verdrängung des Materials des Lotmaterialformstücks (24, 51) mittels eines Druckstempels (58) mit konvex ausgebildeter Kontaktfläche (59) erfolgt, derart, dass neben einer radialen Verdrängung auch eine axiale Verdrängung des Materials entgegen der Druckrichtung des Druckstempels erfolgt.

4. Verfahren nach Anspruch 3,
**dadurch gekennzeichnet,**
**dass** die Druckbeaufschlagung mittels eines auf seiner Kontaktfläche (59) mit einer Zentriereinrichtung (61) versehenen Druckstempels (58) erfolgt.

5. Verfahren nach einem der Ansprüche 1 bis 4,
**dadurch gekennzeichnet,**
**dass** in einem nachfolgenden Verfahrensschritt das Material des Kontaktformstücks (42, 50, 52) zumindest anteilig umgeschmolzen wird.

6. Verfahren nach Anspruch 5,
**dadurch gekennzeichnet,**
**dass** das Umschmelzen mittels Laserenergie erfolgt.

7. Verfahren nach einem der vorangehenden Ansprüche,
**dadurch gekennzeichnet,**
**dass** vor Einbringung des Lotmaterialformstücks (24) in die Substratausnehmung (15) auf der Unterseite (19) des Trägersubstrats zwischen dem Trägersubstrat (12) und dem Gegenhalter (23) eine zweite Anschlussleiteranordnung (14) angeordnet wird, derart, dass die zweite Anschlussleiteranordnung zumindest anteilig einen Boden (20) der Substratausnehmung bildet.

8. Verfahren nach einem der Ansprüche 1 bis 6,
**dadurch gekennzeichnet,**
**dass** vor Einbringung des Lotmaterialformstücks in die Substratausnehmung auf der Unterseite des Trägersubstrats zwischen dem Trägersubstrat und dem Gegenhalter eine zweite Anschlussleiteranordnung angeordnet wird, derart, dass sich die zweite Anschlussleiteranordnung längs eines unteren Öffnungsrands der Substratausnehmung erstreckt.

9. Verfahren nach Anspruch 7 oder 8,
**dadurch gekennzeiehnet,**
dass die zweite Anschlussleiteranordnung (14) auf einem weiteren Trägersubstrat (11) angeordnet ist.

10. Verfahren nach einem der vorangehenden Ansprüche,
**dadurch gekennzeiehnet,**
dass vor dem Umschmelzen des Kontaktformstücks (50) in der Substratausnehmung (15) auf den Kontaktkopf (29) ein weiteres Lotmaterialformstück (34) aufgebracht wird und anschließend das Lotmaterial zumindest anteilig umgeschmolzen wird.

11. Verfahren nach Anspruch 10,
**dadurch gekennzeichnet,**
**dass** das Umschmelzen mittels Laserenergie erfolgt.

12. Kontaktsubstrat mit einer Durchkontaktierung umfassend ein Trägersubstrat und eine auf dem Trägersubstrat angeordnete Leiterbahnstruktur, wobei die Leiterbahnstruktur eine erste auf einer Unterseite des Trägersubstrats angeordnete Anschlussleiteranordnung und eine zweite, auf einer Oberseite des Trägersubstrats angeordnete Anschlussleiteranordnung umfasst, und sich zwischen den Anschlussanordnungen eine Substratausnehmung erstreckt, derart, dass die untere Anschlussleiteranordnung zumindest anteilig einen Boden der Substratausnehmung bildet, und die obere Anschlussleiteranordnung sich zumindest anteilig um einen Öffnungsrand der Substratausnehmung erstreckte, wobei die Durchkontaktierung zwischen der unteren Anschlussleiteranordnung (14, 42) und der oberen Anschlussleiteranordnung (21, 46) durch ein Kontaktformstück (47, 50, 52) gebildet wird, derart, dass das Kontaktformstück die Substratausnehmung (15, 43) vollständig ausfüllt, das Kontaktformstück an seinem, dem Boden (20) der Substratausnehmung gegenüberliegenden Ende einen den Öffnungsrand (22) sowohl axial als auch radial überragenden Kontaktkopf (29, 48) aufweist, der mit der oberen Anschlussleiteranordnung kraftschlüssig verbunden ist, **dadurch gekennzeichnet, dass** dadurch eine mechanische Verbindung zwischen den Anschlussleiteranordnungen zum Befestigen der Anschlussleiteranordnungen auf dem Trägersubstrat vorgesehen ist, wobei die Leiterbahnstruktur unabhängig vom Trägersubstrat gebildet ist.

13. Kontaktsubstrat nach Anspruch 12,
**dadurch gekennzeichnet,**
**dass** der Kontaktkopf (29, 48) scheibenförmig ausgebildet ist und eine im Wesentlichen ebene, parallel zur Oberfläche des Trägersubstrats (12, 40) ausgebildete Kontaktfläche (56, 57) aufweist.

14. Kontaktsubstrat nach Anspruch 12,
**dadurch gekennzeichnet,**
**dass** der Kontaktkopf als meniskusförmige Kontakterhöhung (54) ausgebildet ist.

15. Kontaktsubstrat mit einer Durchkontaktierung umfassend ein Trägersubstrat und eine auf dem Trägersubstrat angeordnete Leiterbahnstruktur, wobei die Leiterbahnstruktur eine erste auf einer Unterseite des Trägersubstrats angeordnete Anschlussleiteranordnung und eine zweite, auf einer Oberseite des Trägersubstrats angeordnete Anschlussleiteranordnung umfasst, und sich zwischen den Anschlussanordnungen eine Substratausnehmung erstreckt, derart, dass die untere Anschlussleiteranordnung zumindest anteilig einen Boden der Substratausnehmung bildet, und die obere Anschlussleiteranordnung sich zumindest anteilig um einen Öffnungsrand der Substratausnehmung erstreckt, wobei die Durchkontaktierung zwischen der unteren Anschlussleiteranordnung (14, 42) und der oberen Anschlussleiteranordnung (21, 46) durch ein Kontaktformstück (47, 50, 52) gebildet wird, **dadurch gekennzeichnet, dass** dadurch das Kontaktformstück an seinem dem Boden (20) der Substratausnehmung gegenüberliegenden Ende eine konkave Kontaktoberfläche mit einem erhöhten Kontaktrand aufweist, der mit der oberen Anschlussleiteranordnung kraftschlüssig verbunden ist.

16. Kontaktsubstrat nach einem der Ansprüche 12 bis 15,
**dadurch gekennzeichnet,**
**dass** die untere Leiterbahnanordnung (14) auf einem weiteren Trägersubstrat (12) angeordnet ist.

## Claims

1. A method for producing a contact substrate with through-plating between a connector arrangement arranged at the top of a dielectric carrier substrate and the underside of the carrier substrate, wherein the connector arrangement extends along an aperture margin of a substrate recess, and the underside of the carrier substrate is supported by a backstop, wherein a formed solder material part (24, 51) is placed in the substrate recess (15, 43), and in a subsequent method-related step said formed solder material part is deformed within the substrate recess so as to form a formed contact part (47, 50), such that radial displacement of the material of the formed solder material part in the substrate recess results in a non-positive connection between an intrados surface (28) of the substrate recess and the connector arrangement (21, 46), and that the formed contact part provides through-plating between the connector arrangement and the underside (19, 41) of the carrier substrate,
**characterized in that**
the connector arrangement is formed independently of the carrier substrate and a mechanical connection is provided between the connector arrangement and the carrier substrate.

2. The method according to claim 1,
**characterized in that**
radial displacement of the material of the formed solder material part (24, 51) takes place by forming a disc-shaped contact head (29, 48) which protrudes both axially and radially beyond the aperture margin (22), with the connector arrangement being accommodated in the region of the aperture margin between the contact head and the top (18, 44) of the carrier substrate (12, 40).

3. The method according to claim 1,
**characterized in that**
radial displacement of the material of the formed solder material part (24, 51) takes place by means of a pressure stamp (58) with a convex contact surface (59), such that, apart from radial displacement, axial displacement of the material against the direction of pressure of the pressure stamp is caused, too.

4. The method according to claim 3,
**characterized in that**
exposure to pressure takes place by means of a pressure stamp (58) which on its contact surface (59) comprises a centering device (61).

5. The method according to any one of claims 1 to 4,
**characterized in that**
in a subsequent method-related step, the material of the formed contact part (42, 50, 52) is at least partly re-melted.

6. The method according to claim 5,
**characterized in that**
re-melting takes place by means of laser energy.

7. The method according to any one of the preceding claims,
**characterized in that**
prior to placing the formed solder material part (24) into the substrate recess (15), a second connector arrangement (14) is arranged on the underside (19) of the carrier substrate, between the carrier substrate (12) and the backstop (23), such that the second connector arrangement at least in part forms a bottom (20) of the substrate recess.

8. The method according to any one of claims 1 to 6,
**characterized in that**
prior to placing the formed solder material part into the substrate recess, on the underside of the carrier substrate between the carrier substrate and the backstop a second connector arrangement is arranged, such that the second connector arrangement extends along a lower aperture margin of the substrate recess.

9. The method according to claim 7 or 8,
**characterized in that**
the second connector arrangement (14) is arranged on a further carrier substrate (11).

10. The method according to any one of the preceding claims,
**characterized in that**
prior to re-melting the formed contact part (50) which is arranged in the substrate recess (15), a further formed solder material part (34) is applied onto the contact head (29), and subsequently the solder material is, at least in part, re-melted.

11. The method according to claim 10,
**characterized in that**
re-melting is carried out via laser energy.

12. A contact substrate with through-plating, comprising a carrier substrate and a conductor path structure arranged on the carrier substrate, wherein the conductor path structure comprises a first connector arrangement which is arranged on the underside of the carrier substrate, and a second connector arrangement which is arranged on the top of the carrier substrate, and wherein a substrate recess extends between the connector arrangements, such that the lower connector arrangement at least in part forms a bottom of the substrate recess, and the upper connector arrangement extends at least in part over an aperture margin of the substrate recess, wherein through-plating between the lower connector arrangement (14, 42) and the upper connector arrangement (21, 46) is formed by way of a formed contact part (47, 50, 52), such that the formed contact part completely fills up the substrate recess (15, 43), and the end of the formed contact part, which end is situated opposite the bottom (20) of the substrate recess, comprises a contact head (29, 48) which protrudes beyond the aperture margin (22) both axially and radially, with said contact head (29, 48) being non-positively connected with the upper connector arrangement,
**characterized in that**
thereby a mechanical connection between the connector arrangements for fixing the connector arrangements on the carrier substrate is provided, wherein the conductor path structure is formed independently of the carrier substrate

13. The contact substrate according to claim 12,
**characterized in that**
the contact head (29, 48) is disc-shaped and comprises an essentially flat contact surface (56, 57) which extends parallel to the surface of the carrier substrate (12, 40).

14. The contact substrate according to claim 12,
**characterized in that**
the contact head is a meniscus-shaped raised contact (54).

15. A contact substrate with through-plating, comprising a carrier substrate and a conductor path structure arranged on the carrier substrate, wherein the conductor path structure comprises a first connector arrangement which is arranged on the underside of the carrier substrate, and a second connector arrangement which is arranged on the top of the carrier substrate, and wherein a substrate recess extends between the connector arrangements, such that the lower connector arrangement at least in part forms a bottom of the substrate recess, and the upper connector arrangement extends at least in part around an aperture margin of the substrate recess, wherein through-plating between the lower connector arrangement (14, 42) and the upper connector arrangement (21, 46) is formed by way of a formed contact part (47, 50, 52),
**characterized in that**
thereby the end of the formed contact part, which end is situated opposite the bottom (20) of the substrate recess, comprises a concave contact surface with a raised contact margin which is non-positively connected with the upper connector arrangement.

16. The contact substrate according to one of claims 12 to 15,
**characterized in that**
the lower conductor part arrangement (14) is arranged on a further carrier substrate (12).

## Revendications

1. Procédé de fabrication d'un substrat de contact avec des trous métallisés entre un ensemble de conducteurs de connexion étant disposé sur un côté supérieur d'un substrat porteur diélectrique et un côté inférieur du substrat porteur, l'ensemble de conducteurs de connexion s'étendant le long d'un bord d'ouverture d'un évidement du substrat, le substrat porteur avec son côté inférieur s'appuyant contre un contre-appui, dans lequel une pièce moulée en matériau de brasage (24, 51) est placée dans l'évidement du substrat (15, 43), et au cours d'une étape subséquente du processus la pièce moulée en matériau de brasage est déformée dans l'évidement du substrat pour devenir une pièce de contact moulée (47, 50) de façon à ce qu'un déplacement radial du matériau de la pièce de contact moulée dans l'évidement du substrat produise une connexion par adhérence entre une surface d'intrados (28) de l'évidement du substrat et l'ensemble de conducteurs de connexion (21, 46) et la pièce de contact moulée forme un trou métallisé entre l'ensemble de conducteurs de connexion et le côté inférieur (19, 41) du substrat porteur,
**caractérisé en ce que**
l'ensemble de conducteurs de connexion est formée indépendamment du substrat porteur et une connexion mécanique est prévue entre l'ensemble de conducteurs de connexion et le substrat porteur.

2. Procédé selon la revendication 1,
**caractérisé en ce que**
le déplacement radial du matériau de la pièce moulée en matériau de brasage (24, 51) s'effectue en formant une tête de contact (29, 48) en forme de disque dépassant axialement et radialement le bord d'ouverture (22), et l'ensemble de conducteurs de connexion est accommodé dans la zone du bord d'ouverture entre la tête de contact et le côté supérieur (18, 44) du substrat porteur (12, 40).

3. Procédé selon la revendication 1,
**caractérisé en ce que**
le déplacement radial du matériau de la pièce moulée en matériau de brasage (24, 51) s'effectue par l'intermédiaire d'un tampon de pression (58) ayant une surface de contact (59) configurée de manière convexe de façon à ce qu'en outre du déplacement radial, un déplacement axial du matériau soit aussi effectué contre la direction de pression du tampon de pression.

4. Procédé selon la revendication 3,
**caractérisé en ce que**
l'application de pression est effectuée par l'intermédiaire d'un tampon de pression (58) étant muni sur sa surface de contact (59) avec un dispositif de centrage (61).

5. Procédé selon l'une quelconque des revendications 1 à 4,
**caractérisé en ce qu'**
au cours d'une étape subséquente du processus, le matériau de la pièce de contact moulée (42, 50, 52) est refondé au moins partiellement.

6. Procédé selon la revendication 5,
**caractérisé en ce que**
la refonte a lieu par l'intermédiaire d'énergie laser.

7. Procédé selon l'une quelconque des revendications précédentes,
**caractérisé en ce qu'**
avant le placement de la pièce moulée en matériau de brasage (24) dans l'évidement du substrat (15), un second ensemble de conducteurs de connexion (14) est disposé sur le côté inférieur (19) du substrat porteur entre le substrat porteur (12) et le contre-appui (23) de façon à ce que le second ensemble de conducteurs de connexion forme au moins partiellement un fond (20) de l'évidement du substrat.

8. Procédé selon l'une quelconque des revendications 1 à 6,
**caractérisé en ce qu'**
avant le placement de la pièce moulée en matériau de brasage dans l'évidement du substrat, un second ensemble de conducteurs de connexion est disposé sur le côté inférieur du substrat porteur entre le substrat porteur et le contre-appui de façon à ce que le second ensemble de conducteurs de connexion s'étende le long d'un bord d'ouverture inférieur de l'évidement du substrat.

9. Procédé selon la revendication 7 ou 8,
**caractérisé en ce que**
le second ensemble de conducteurs de connexion (14) est disposé sur un autre substrat porteur (11).

10. Procédé selon l'une quelconque des revendications précédentes,
**caractérisé en ce qu'**
avant la refonte de la pièce de contact moulée (50) dans l'évidement du substrat (15), une autre pièce moulée en matériau de brasage (34) est appliquée sur la tête de contact (29) et le matériau de brasage est ensuite refondé au moins partiellement.

11. Procédé selon la revendication 10,
**caractérisé en ce que**
la refonte a lieu par l'intermédiaire d'énergie laser.

12. Substrat de contact avec un trou métallisé comprenant un substrat porteur et une structure de pistes conductrices disposée sur le substrat porteur, la structure de pistes conductrices comprenant un premier ensemble de conducteurs de connexion disposé sur un côté inférieur du substrat porteur, et comprenant un second ensemble de conducteurs de connexion disposé sur un côté supérieur du substrat porteur, un évidement du substrat s'étendant entre les ensembles de connexion de façon à ce que l'ensemble de conducteurs de connexion inférieur forme au moins partiellement un fond de l'évidement du substrat, et l'ensemble de conducteurs de connexion supérieur s'étende au moins partiellement le long d'un bord d'ouverture de l'évidement du substrat, dans lequel le trou métallisé est formé entre l'ensemble de conducteurs de connexion inférieur (14, 42) et l'ensemble de conducteurs de connexion supérieur (21, 46) par l'intermédiaire d'une pièce de contact moulée (47, 50, 52) de façon à ce que la pièce de contact moulée remplisse complètement l'évidement du substrat (15, 43), et la pièce de contact moulée à son extrémité faisant face au fond (20) de l'évidement du substrat présente une tête de contact (29, 48) dépassant axialement et radialement le bord d'ouverture (22), la tête de contact étant reliée par adhérence avec l'ensemble de conducteurs de connexion supérieur,
**caractérisé en ce que**
par cela une connexion mécanique est réalisée entre les ensembles de conducteurs de connexion pour fixer les ensembles des conducteurs de connexion sur le substrat porteur, la structure de pistes conductrices étant formée indépendamment du substrat porteur.

13. Substrat de contact selon la revendication 12,
**caractérisé en ce que**
la tête de contact (29, 48) est configurée en forme de disque et présente une surface de contact (56, 57) qui est conçue essentiellement plaine et en parallèle à la surface du substrat porteur (12, 40).

14. Substrat de contact selon la revendication 12,
**caractérisé en ce que**
la tête de contact est configurée en tant que contact élevé (54) en forme de ménisque.

15. Substrat de contact avec un trou métallisé comprenant un substrat porteur et une structure de pistes conductrices disposée sur le substrat porteur, la structure de pistes conductrices comprenant un premier ensemble de conducteurs de connexion disposé sur un côté inférieur du substrat porteur, et comprenant un second ensemble de conducteurs de connexion disposé sur un côté supérieur du substrat porteur, un évidement du substrat s'étendant entre les ensembles de connexion de façon à ce que l'ensemble de conducteurs de connexion inférieur forme au moins partiellement un fond de l'évidement du substrat et l'ensemble de conducteurs de connexion supérieur s'étende au moins partiellement le long d'un bord d'ouverture de l'évidement du substrat, dans lequel le trou métallisé entre l'ensemble de conducteurs de connexion (14, 42) inférieur et l'ensemble de conducteurs de connexion supérieur (21, 46) est formé par l'intermédiaire d'une pièce de contact moulée (47, 50, 52),
**caractérisé en ce que**
par cela la pièce de contact moulée (47, 50, 52) à son extrémité faisant face au fond (20) de l'évidement du substrat présente une surface de contact concave ayant un bord de contact élevé qui est relié par adhérence avec l'ensemble de conducteurs de connexion supérieur.

16. Substrat de contact selon l'une quelconque des revendications 12 à 15,
**caractérisé en ce que**
l'ensemble de pistes conductrices (14) inférieur est disposé sur un autre substrat porteur (12).
